# EUROPÄISCHE PATENTSCHRIFT

(11) **EP 3 161 862 B1**
(45) Veröffentlichungstag und Bekanntmachung des Hinweises auf die Patenterteilung: **31.01.2018**
(21) Anmeldenummer: 14739077.7
(22) Anmeldetag: 27.06.2014
(51) Int. Cl.: H01L 21/67, B32B 43/00, H01L 21/683

(54) **VERFAHREN ZUM LÖSEN EINES ERSTEN SUBSTRATS**
METHOD FOR RELEASING A FIRST SUBSTRATE
LA MÉTHODE D'ENLEVER UN PREMIER SUBSTRAT

(43) Veröffentlichungstag der Anmeldung: 03.05.2017
(73) Patentinhaber: Thallner, Erich, 4782 St. Florian (AT)
(72) Erfinder: Thallner, Erich, 4782 St. Florian (AT)
(74) Vertreter: Schneider, Sascha
(86) Internationale Anmeldenummer: PCT/EP2014/063687
(87) Internationale Veröffentlichungsnummer: WO 2015/197132

(56) Entgegenhaltungen:
- EP-A2- 1 523 030
- WO-A2-2013/063603
- US-A1- 2010 263 794

## Beschreibung

Die Erfindung betrifft ein Verfahren gemäß Anspruch 1.

pIn der Halbleitertechnik werden Substrate regelmäßig rückgedünnt, um die Dimension der entstehenden Bauteile zu reduzieren. Einer der häufigsten Gründe zur Anwendung des Rückdünnens ist die Herstellung von elektrisch leitfähigen Verbindungen durch das Substrat. Diese Leitungen werden, insbesondere wegen deren häufiger Verwendung in Siliziumsubstraten, through-silicon-vias (TSVs) genannt. Da die industriell gefertigten Substrate, insbesondere Wafer, eine Dicke von mehr als 500 µm besitzen, die TSVs allerdings nur eine Länge von ca. 100 µm aufweisen, ist es notwendig, die restlichen Teiles des Substrats zu entfernen. Am Ende des Rückdünnprozesses soll ein Funktionswafer mit einer möglichst geringen Dicke entstehen. Die Dicke hängt von den technischen und elektrischen Eigenschaften ab.

Die Druckschrift WO 2013/063603 beschreibt ein Verfahren zur kontrollierten Störung eines adhäsiven Bonds zwischen einem Produktwafer und einem Trägerwafer. Die Druckschrift EP 1523030 A2 offenbart ein Verfahren, bei dem die Oberfläche eines Trägers angesaugt und erhitzt wird, wodurch die Klebestärke einer Klebeschicht fast verschwindet. Die Druckschrift US 2010/0263794 A1 offenbart einen Debonder, bei dem ein Kontaktroller eine Kante einer flexiblen Platte verbiegt und die Trennung eines Waferpaares entlang einer Ablöseschicht verursacht.

Die Produktsubstrate werden auf Trägersubstraten fixiert, damit sie während, und vor allem nach dem Rückdünnprozess mechanisch stabilisiert sind. Es werden vorwiegend Halbleitersubstrate oder Glassubstrate als Trägersubstrate verwendet. Die Produktsubstrate werden nach dem Bonden mit dem Trägersubstrat verschiedenen Prozessen unterworfen. Insbesondere werden auf den Produktsubstraten funktionale Einheiten, beispielsweise MEMs; Mikrochips, Speichereinheiten etc. geformt.

Nach dem Rückdünnen und weiteren Prozessen muss das Produktsubstrat vom Trägersubstrat gelöst werden um weiterverarbeitet werden zu können.

Den Vorgang der Fixierung nennt man Bonden. Ist die Fixierung zeitlich begrenzt, spricht man vom temporären Bonden oder Temporärbonden. Zum temporären Bonden werden verschiedene Materialien verwendet, die eine Fixierung der beiden Substrate während der unterschiedlichen Prozessschritte ermöglichen, anderseits aber unter gewissen chemischen und/oder physikalischen Einwirkungen eine Trennung der Substrate erlauben. Die Klebeverbindungen können beispielsweise zwischen Produktsubstrat und Trägersubstrat chemisch gelöst werden. Eine weitere Methode ist die Trennung der Substrate durch Wärmeeinwirkung und dem Aufbringen einer Scher- und/oder Normalkraft. Eine weitere Methode besteht in der Zerstörung des Klebers durch elektromagnetische Strahlung, insbesondere durch UV Licht. Dazu muss mindestens eines der beiden Substarte transparent für das UV Licht sein.

Alle diese bisher bekannten Methoden weisen erhebliche Nachteile auf, die zu einer zumindest teilweisen Beeinträchtigung der Eigenschaften der Verbindungsschicht und/oder der Substrate oder darauf angeordneter Bauteile führen können.

Beim Debonden/Lösen des Trägersubstrats vom Produktsubstrate sind eine Vielzahl kritischer Faktoren zu berücksichtigen und oberste Priorität besteht darin, den brüchigen und auf Grund der Vorbearbeitung sehr teuren Produktwafer möglichst geringem Stress auszusetzen und diesen nicht zu beschädigen. Das Ablösen des ersten Substrats soll auf der anderen Seite kostengünstig und schnell mit geringst möglichem Energieaufwand erfolgen. Bei einer Vielzahl von bekannten Ablöseprozessen ist es erforderlich, insbesondere zur Auflösung der Adhäsionseigenschaften der Adhäsionsschicht zwischen den Wafern, den "Stack" (Stapel) aus Trägerwafer und Strukturwafer/Produktwafer auf eine für den Kleber spezifische Temperatur aufzuheizen.

Aufgabe der vorliegenden Erfindung ist es, die gattungsgemäßen Vorrichtungen und Verfahren zum Ablösen von ersten Substraten derart weiterzubilden, dass ein schonendes und schnelles Ablösen ermöglicht wird. Gleichzeitig soll der Energieverbrauch reduziert werden.

Diese Aufgabe wird mit den Merkmalen des Patentanspruchs 1 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Zeichnungen angegebenen Merkmalen. Bei Wertebereichen sollen auch innerhalb der genannten Grenzen liegende Werte als Grenzwerte offenbart und in beliebiger Kombination beanspruchbar sein.

Grundgedanke der vorliegenden Erfindung ist es, durch Abkühlung und/oder Versprödung einer Verbindungsschicht und/oder Abkühlung der Substrate und/oder eines aus der Verbindungsschicht und den Substraten gebildeten Substratstapels ein Lösen der Substrate zu ermöglichen oder zu bewirken.

Die Erfindung beschreibt insbesondere ein Verfahren und eine Anlage/Vorrichtung zum Lösen/Debonden zweier Substrate, insbesondere Wafer, durch Kühlung mittels eines Kühlmittels. Der Erfindung liegt dabei insbesondere der Gedanke zugrunde, eine Verbindungsschicht (insbesondere einen Kleber) zum Bonden zweier Substrate zu verwenden, der bei niedrigen Temperaturen, insbesondere unterhalb der Raumtemperatur, versprödet. Dabei werden insbesondere die mechanische Stabilität und/oder die Adhäsionswirkung der Verbindungsschicht reduziert.

Anstelle einer Erhitzung zur Reduktion der Viskosität, der mechanischen Stabilität und/oder der Adhäsionseigenschaften, wird bei dem erfindungsgemäßen Verfahren der gesamte Substratstapel abgekühlt, um die Verbindungsschicht zu verspröden. Die Versprödung erfolgt derart, dass eine Trennung beider Substrate mit relativ geringer mechanischer Kraft möglich wird. Die mechanische Kraft kann, abhängig von der jeweiligen erfindungsgemäßen Ausführungsform als Scherkraft oder als Normalkraft angelegt werden.

Bei den Normalkräften kann es sich insbesondere um eine Punktkraft, eine Linienkraft oder eine Flächenkraft handeln. Zur Trennung zweier Oberflächen wird die Energie pro Einheitsfläche, im weiteren Verlauf als Energiedichte bezeichnet, angegeben, die zur Trennung zweier Körper mindestens notwendig ist. Die Energiedichte zwischen den beiden Substraten ist erfindungsgemäß insbesondere kleiner als 2.5 J/m², vorzugsweise kleiner als 2.0 J/m², noch bevorzugter kleiner als 1.5 J/m², am bevorzugtesten kleiner als 1.0 J/m², am allerbevorzugtesten kleiner als 0.5 J/m².

Insbesondere erfolgt die Trennung durch die Versprödung und/oder durch die Abkühlung auftretende Eigenspannung bereits beim Abkühlprozess selbsttätig, also vorzugsweise ausschließlich durch das Abkühlen bedingt. Der Kleber wird insbesondere nicht in einen zähflüssigeren, sondern durch Kälteeintrag in einen verhärteten, verspröden Zustand überführt.

Mit anderen Worten besteht der Kern der Erfindung insbesondere in der Versprödung eines Materials der Verbindungsschicht, insbesondere eines Klebers, noch bevorzugter eines Bondingadhäsives, zur Reduktion der mechanischen Stabilität und/oder der Adhäsionseigenschaften der Verbindungsschicht. Die Erfindung beschreibt somit Methoden und Anlagen, um die erfindungsgemäße Versprödung zu bewerkstelligen.

Die Erfindung löst ein seit Jahren bestehendes Problem des Debondens bei erhöhter Temperatur. Der Diffusionskoeffizient einer Komponente in einem Medium, insbesondere der Diffusionskoeffizient eines Metallatoms in einer Metall- oder Halbmetallmatrix, ist eine explizite Funktion der Temperatur. Erhöhte Temperaturen bedeuten eine gesteigerte Diffusionseigenschaft der Spezies im Medium. Die Diffusion läuft daher im Allgemeinen umso schneller, je höher die Temperatur, bzw. umso langsamer, je geringer die Temperatur ist, ab. Produktsubstrate besitzen sehr oft bereits dotierte Halbleiterkomponenten, insbesondere Mikrochips oder Speicherchips. Eine erhöhte Temperaturbelastung während eines Debondvorgangs kann zu einer ungewollten Diffusion der Dotierungselemente führen. Durch die nachfolgend beschriebenen, erfindungsgemäßen Ausführungsformen und Methoden wird der Substratstapel insbesondere nicht erhitzt, sondern gekühlt. Damit wird eine etwaige, ungewollte Diffusion von Dotierelementen deutlich verlangsamt.

Ein weiterer erfindungsgemäßer Vorteil besteht in der gesteigerten Debondgeschwindigkeit. Durch den erfindungsgemäßen Vorgang können zwei, insbesondere vollflächig gebondete, Substrate innerhalb weniger Sekunden voneinander getrennt werden. Die Senkung der Debondzeit hat eine Steigerung des Durchsatzes und damit eine höhere Wirtschaftlichkeit zur Folge.

Gemäß einer vorteilhaften Ausführungsform der Erfindung sind Kühleinheiten als Kühlmittel zur Abkühlung als Substrathalter/Probenhalter zur Aufnahme und Halterung des/der Substrate ausgebildet. Diese weisen insbesondere entsprechende Fixierelemente, insbesondere Vakuumleitungen, auf. Bevorzugt ist/sind die Kühleinheit(en) und Fixerelemente voneinander örtlich getrennt und/oder eigenständig bewegbar. Insbesondere sind Zu- und Abflüsse für ein Kühlmittel nachführbar ausgebildet, vorzugsweise als Schlauch oder flexible Rohrkonstruktion,

Erfindungsgemäße Ausführungsformen beschreiben Vorrichtungen/Anlagen und Verfahren, um einen Substratstapel zu kühlen und dadurch ein schonendes Ablösen zu ermöglichen. Durch die Kühlung des Substratstapels wird (bevorzugt mittelbar, also ohne unmittelbaren Kontakt mit der Verbindungsschicht) die Verbindungsschicht, insbesondere der Kleber, vorzugsweise ein Bondingadhäsiv, gekühlt.

Ein erfindungsgemäße Gedanke besteht insbesondere darin, ein Material für die Verbindungsschicht zu verwenden, das sich bei Raumtemperatur oder leicht erhöhter Temperatur zum Bonden der Substrate eignet, bei tieferen Temperaturen zumindest teilweise, insbesondere vollständig, versprödet und damit entweder seine Adhäsionseigenschaften zu den Oberflächen der Substrate verliert oder entlang seines Volumens zumindest trennbar ist, sodass eine Trennung der beiden Substrate des Substratstapels voneinander erfolgen kann.

### Substratstapel

Der Substratstapel besteht aus mindestens zwei Substraten, die durch eine Verbindungsschicht, insbesondere einen Kleber, miteinander verbondet werden/wurden. Denkbar sind auch Substratstapel mit mehr als zwei Substraten, wobei immer zwei Substrate mit einem Kleber miteinander verbunden sind. Im weiteren Verlauf werden der Einfachheit halber Substratstapel mit zwei Substraten behandelt. Der Substratstapel kann auf einer Folie (engl.: tape) befestigt werden, die insbesondere auf einen Rahmen (engl.: frame) laminiert wurde. Diese Ausführungsform wird insbesondere für die Fixierung bereits rückgedünnter Substrate (Produktsubstrate) verwendet.

### Verbindungsschicht(system), insbesondere Klebersysteme

Erfindungsgemäß kann jede Verbindungsschicht, die zum Bonden zweier Substrate geeignet ist und unterhalb einer kritischen Temperatur versprödet, verwendet werden.

Bei erfindungsgemäß bevorzugten Klebern kann es sich um Einschichtkleber, Mehrschichtkleber oder Kleber mit strukturierten Schichten handeln. Das Material einer jeden Schicht kann ein Ein- oder Mehrkomponentensystem sein.

Die Schichtdicke einer jeden Schicht der Verbindungsschicht ist erfindungsgemäß insbesondere kleiner als 1 mm, vorzugsweise kleiner als 500 µm, noch bevorzugter kleiner als 100 µm, am bevorzugtesten kleiner als 1 µm, am allerbevorzugtesten kleiner als 10 nm.

Die Verbindungsschichtdicke, die sich als Summe der Schichtdicken einzelner Schichten ergibt, ist erfindungsgemäß insbesondere kleiner als 1 mm, vorzugsweise kleiner als 500 µm, noch bevorzugter kleiner als 100 µm, am bevorzugtesten kleiner als 1 µm, am allerbevorzugtesten kleiner als 10 nm. Bei Substraten mit einer Oberflächentopographie ist die Summe der Schichtdicken mindestens so groß wie die höchste Topographie, insbesondere um mindestens 1 nm größer, noch bevorzugter um mindestens 10 nm größer, am bevorzugtesten um mindestens 100 nm größer, am allerbevorzugtesten um mindestens 1 µm größer, am allerbevorzugtesten um mindestens 10 µm größer.

In einer ersten erfindungsgemäßen Ausführungsform ist die Verbindungsschicht ein Einkomponentensystem. Insbesondere werden Materialien verwendet, die auf einer der folgenden Komponenten basieren:
- Silikone und/oder
- Kunststoffe, insbesondere
   ∘ Thermoplaste,
   ∘ Duroplaste,
   ∘ Elastomere,
- Wachs.

Der Klebstoff kann beispielsweise einer der folgenden Klassen zugeordnet werden...
- Physikalisch abbindende Klebstoffe, insbesondere
   ∘ Haft und Kontaktklebstoffe
   ∘ Schmelzklebstoffe
   ∘ Lösungsmittel- bzw. Dispersionsklebstoffe von im Endzustand vorliegenden Polymeren,
   ∘ Dispersionsklebstoffe
   ∘ Wasser- bzw. Lösungsmittelaktivierbare Klebstoffe
   ∘ Plastiole
- Chemisch härtende Klebstoffe, insbesondere
   ∘ Polymerisationsklebstoffe, insbesondere
      ▪ Akrylat-Klebstoffe, insbesondere,
         - Methylmethacrylat-Klebstoffe
         - Cyanacrylat-Klebstoffe
      ▪ Ungesättigte Polyester
   ∘ Polykondensationsklebstoffe, insbesondere
      ▪ Phenol-Formaldehydharz-Klebstoffe
      ▪ Silikone
      ▪ Silanverbindende Polymerklebstoffe
      ▪ Polyimidklebstoffe
      ▪ Polysulfidklebstoffe
   ∘ Polyadditionsklebstoffe, insbesondere
      ▪ Epoxidharz-Klebstoffe
      ▪ Polyurethan-Klebstoffe
      ▪ Silikone
- Reaktive Schmelzklebstoffe, insbesondere
   ∘ Polyamide
   ∘ Polyethylene
   ∘ Amorphe Polyalphaolefine
   ∘ Ethylenvinylacetat-Copolymere
   ∘ Polyester-Elastomere
   ∘ Polyurethan-Elastomere
   ∘ Copolyamid-Elastomere
   ∘ Vinylpyrrolidon/Vinylacetat-Copolymere

Bei dem Kleber kann es sich bevorzugt um ein Cycloolefin-Copolymer (COC) handeln.

In einer zweiten erfindungsgemäßen Ausführungsform ist die Verbindungsschicht eine Mehrkomponentenverbindung. Insbesondere werden Komponenten verwendet, welche die Sprödbrucheigenschaften maßgeblich beeinflussen. Derartige Komponenten können sein
- Organische Komponenten, insbesondere organische Moleküle, noch bevorzugter Moleküle für Antihaftschichten (engl.: anti sticking layer, ASL) und/oder
- Anorganische Komponenten, insbesondere anorganische Moleküle und/oder
- Metalle, insbesondere Metallionen und/oder
- Metalllegierungen und/oder
- Keramiken.

In einem erfindungsgemäßen Mehrkomponentensystem wird die Komponente, die mengen- und/oder massenmäßig im Überschuss vorkommt, als Matrix bezeichnet. Komponenten, die mengen- und/oder massenmäßig in geringerem Anteil vorkommen, werden auch als Additive bezeichnet. Additive werden vorzugsweise entlang der gesamten Verbindungsfläche des Klebers hinzugefügt. Erfindungsgemäß denkbar ist auch eine örtlich begrenzte Hinzugabe von Additiven, insbesondere entlang einer, vorzugsweise vollumfänglichen, Umfangskontur der Verbindungsschicht.

In einer weiteren Verbesserung der erfindungsgemäßen Ausführungsformen wird die Verbindungsschicht als ein Mehrschichtsystem ausgebildet, wobei jede Schicht entweder ein Einkomponentensystem oder ein Mehrkomponentensystem ist. Jede einzelne Schicht kann daher, insbesondere in Bezug auf die jeweils benachbarte Schicht, unterschiedliche chemische und/oder physikalische Eigenschaften besitzen. Nicht jede Schicht muss Klebeeigenschaften besitzen.

In einer bevorzugten Ausführungsform wird mindestens eine der Schichten ohne oder mit geringer Klebewirkung ausgebildet, die, insbesondere ausschließlich, zur Versprödung bzw. Trennung des Schichtsystems und damit der beiden Substrate voneinander dient.

Gemäß einer weiteren Verbesserung der erfindungsgemäßen Ausführungsform ist mindestens eine der Schichten, insbesondere in einem Mehrschichtensystem, strukturiert ausgebildet. Die Strukturierung erfolgt insbesondere durch photo- und/oder prägelithographische Prozesse. Die Strukturierung erlaubt die Herstellung einer aus unterschiedlichen Materialien bestehenden Kompositschicht. Diese Kompositschicht besitzt insbesondere makroskopisch homogene und/oder isotrope Eigenschaften, und/oder ist mikroskopisch inhomogen und/oder anisotrop.

Die Dimensionen der, insbesondere durch Photo- und/oder Prägelithographie hergestellten, Strukturen sind insbesondere kleiner als 100 µm, vorzugsweise kleiner als 50 µm, noch bevorzugter kleiner als 1 µm, am bevorzugtesten kleiner als 100 nm, am allerbevorzugtesten kleiner als 10 nm.

### Das Kühlmittel, insbesondere Kühlfluid

Als Kühlmittel zum Abkühlen der Verbindungsschicht wird insbesondere ein Kühlfluid verwendet, das vorzugsweise ein Flüssigkeitsgemisch, eine Flüssigkeit, ein Gasgemisch, ein Gas und/oder ein Flüssig-Gas Gemisch ist. Vorzugsweise handelt es sich um eine Flüssigkeit oder ein Gas.

Das Kühlmittel, insbesondere Kühlfluid, dient der Aufnahme und dem Abtransport der Wärme der Verbindungsschicht, insbesondere des Substratstapels, und ggf. der näheren Umgebung des Substratstapels. Dadurch kommt es zur erfindungsgemäßen Abkühlung der Verbindungsschicht.

Theoretisch können Körper auf eine Temperatur von ca. 0 K (-273.15°C) gekühlt werden. Derartig tiefe Temperaturen werden allerdings nur in speziell dafür ausgerichteten Laboren und durch aufwendige Apparaturen erreicht. Erfindungsgemäß erreichbare technische Tieftemperaturen liegen insbesondere in der Nähe des Siedepunkts flüssigen Heliums und/oder bevorzugt des flüssigen Stickstoffs. Der Siedepunkt des Heliums liegt bei ca. 4,15 K (-269.00°C), der Siedepunkt des Stickstoffs bei ca. 77 K (-196.15°C).

In einer ersten erfindungsgemäßen Erweiterung ist das Kühlfluid eine Flüssigkeit. Der Siedepunkt des verwendeten Kühlfluids ist insbesondere kleiner als 0°C, vorzugsweise kleiner als -50°C, noch bevorzugter kleiner als -100°C, am bevorzugtesten kleiner als -150°C, am aller bevorzugtesten kleiner als -200°C. Die bevorzugt als Kühlfluid verwendeten verflüssigten Gase Helium und/oder Stickstoff sind darüber hinaus inert, nicht entflamm- oder entzündbar, wenig reaktiv. Schutzvorrichtungen zur Verhinderung eines Erstickungstods können bevorzugt, insbesondere in einem abgeschlossenen Clustersystemen, eingerichtet werden. Des Weiteren kann gemäß einer vorteilhaften Ausführungsform durch die Installation von Sauerstoffsensoren die Verdrängung von Sauerstoff durch entsprechende Gase gemessen werden. In einer zweiten und bevorzugten erfindungsgemäßen Erweiterung ist das Kühlfluid ein Gas. Das Gas wird in einem vorgekühlten, insbesondere nicht oder nur leicht komprimierten Zustand, zum Abkühlen verwendet. Der Druck des Gases ist dabei insbesondere kleiner als 5 bar, vorzugsweise kleiner als 3 bar, noch bevorzugter kleiner gleich 1 bar.

In einer besonders bevorzugten, alternativen Ausführungsform wird reine Luft aus der Umgebung durch Kompressoren auf mehr als 20 bar, insbesondere mehr als 50 bar, noch bevorzugter mehr als 100 bar, am bevorzugtesten mehr als 150 bar, am allerbevorzugtesten mehr als 200 bar komprimiert. Durch eine isenthalpische Expansion der Luft auf einen Druck von weniger als 100 bar, insbesondere weniger als 50 bar, noch bevorzugter weniger als 25 bar, am bevorzugtesten weniger als 10 bar, am allerbevorzugtesten weniger als 5 bar wird eine Temperaturerniedrigung von mehreren Grad Celsius bewirkt, die zur erfindungsgemäßen Abkühlung der Verbindungsschicht benutzt wird. Insbesondere wird durch eine derartige isenthalphische Expansion eine Temperaturerniedrigung von mehr als 5 °C, insbesondere mehr als 10 °C, noch bevorzugter mehr als 25 °C, am bevorzugtesten mehr als 35 °C, am allerbevorzugtesten mehr als 45 °C erreicht. Die Temperaturabnahme bewirkt insbesondere zumindest teilweise, vorzugsweise überwiegend, noch bevorzugter vollständig, den erfindungsgemäßen Effekt der Versprödung der entsprechend ausgewählten Verbindungsschicht, die vom Material her zumindest in einer Schicht auf den entsprechenden Temperaturbereich ausgelegt ist.

In einer weiteren, besonders bevorzugten Ausführungsform wird das Kühlfluid zur zyklischen, daher mehrmaligen Kühlung verwendet. Die erfindungsgemäße Verbindungsschicht wird dabei mehr als 1-mal, bevorzugter mehr als 5-mal, noch bevorzugter mehr als 10-mal, am bevorzugtesten mehr als 15-mal, am allerbevorzugtesten mehr als 20-mal gekühlt und erwärmt. Die Temperatur der Verbindungsschicht wechselt dabei zwischen Temperaturwerten oberhalb bzw. unterhalb der kritischen Temperatur. Die Erwärmung der Verbindungsschicht kann dabei mit einem heißen Fluid, insbesondere einem Heizgas und/oder einer Heizflüssigkeit erfolgen.

In Weiterbildung der erfindungsgemäßen Ausführungsformen werden das Kühlfluid und das Heizfluid in zwei separaten Kammern zur Verfügung gestellt, zwischen denen der Substratstapel (und damit die Verbindungsschicht) transferiert werden kann, um einen sehr schnellen Temperaturwechsel zu bewirken.

Erfindungsgemäß wird insbesondere ein Kühlfluid gewählt, dessen spezifische Wärmekapazität so groß wie möglich ist, um eine Speicherung von Energie in Form von Wärme zu begünstigen. Die spezifische Wärmekapazität liegt vorzugsweise zwischen 0.0 kJ/(kg*K) und 20 kJ/(kg*K), vorzugsweise zwischen 0.5 kJ/(kg*K) und 20 kJ/(kg*K), noch bevorzugter zwischen 1.0 kJ/(kg*K) und 20 kJ/(kg*K), am bevorzugtesten zwischen 10 kJ/(kg*K) und 20 kJ/(kg*K), am allerbevorzugtesten zwischen 15 kJ/(kg*K) und 20 kJ/(kg*K).

Erfindungsgemäß wird insbesondere ein Kühlfluid gewählt, dessen Wärmeleitfähigkeit so groß wie möglich ist, um einen schnellen Abtransport der Wärme entlang der Kühlfluidstrecke zu gewährleisten. Die Wärmeleitfähigkeit liegt vorzugsweise zwischen 0.01 W/(m*K) und 10 W/(m*K), vorzugsweise zwischen 0.05 W/(m*K) und 10 W/(m*K), noch bevorzugter zwischen 0.1 W/(m*K) und 10 W/(m*K), am bevorzugtesten zwischen 0.5 W/(m*K) und 10 W/(m*K).

### Versprödungsmechanismen

Ein erfindungsgemäßer Gedanke besteht in der Verwendung einer Verbindungsschicht (insbesondere eines Klebers) die durch äußere Einflüsse, insbesondere durch Temperaturerniedrigung unter eine kritische Temperatur (Versprödungstemperatur), versprödet werden kann. Unter Versprödung soll erfindungsgemäß jeder chemische und/oder physikalische Vorgang verstanden werden, der die erfindungsgemäße Verbindungsschicht so beeinflusst, dass die durch die Verbindungsschicht verbondeten Substrate voneinander mit geringem Kraftaufwand oder sogar ohne Kraftaufwand trennbar sind. Der Begriff "Versprödung" wird daher weiter gefasst als ihn der Fachmann verstehen würde. Die benötigte Kraft zum Trennen der Substrate des Substratstapels ist insbesondere kleiner als 100 kN, vorzugsweise kleiner als 10 kN, noch bevorzugter kleiner als 1 kN, am bevorzugtesten kleiner als 100 N, am allerbevorzugtesten kleiner als 10 N.

Erfindungsgemäß ist Versprödung insbesondere durch eine Abnahme der Duktilität im werkstoffwissenschaftlichen und/oder physikalischen Sinn gekennzeichnet. Die Abnahme der Duktilität und die Zunahme der Sprödigkeit ist, insbesondere für Polymerwerkstoffe, primär beziehungsweise überwiegend ein Vernetzungseffekt. Unter einer Vernetzung wird erfindungsgemäß insbesondere eine, vorzugswese räumliche, Ausbildung chemischer, insbesondere kovalenter, Verbindungen verstanden. Die Vernetzung erfolgt bevorzugt zwischen vorhandenen Polymerketten und führt am Ende des Vernetzungsprozesses zu einem räumlichen Netz, insbesondere einem Makromolekül. Je höher der Vernetzungsgrad, desto weniger vereinzelte Polymerketten existieren, die sich an einer elastischen und/oder plastischen Verformung des Materials der Verbindungsschicht beteiligen könnten. In einem vollständig vernetzten Polymer, insbesondere bei Duromeren, sind elastische Eigenschaften reine elektrostatische Phänomene, die auf den Bindungskräften zwischen den miteinander vernetzten Polymerketten beruhen. Effekte wie Entropieelastizität bzw. Streckung von Polymerketten unter einer externen Zugbelastung sind in Duromeren praktisch nicht möglich. Daher reagieren derartige Materialien sehr spröde, im Idealfall ideal spröd, auf externe mechanische Belastungen, insbesondere Zugbelastungen.

Alternativ oder zusätzlich ist Versprödung erfindungsgemäß insbesondere durch eine Immobilisierung von Polymerketten der Verbindungsschicht gekennzeichnet, insbesondere hervorgerufen durch geringe thermische Bewegung bei tiefen Temperaturen. Durch sehr tiefe Temperaturen kann die Streckung der Polymerketten, insbesondere durch eine äußere Zugbelastung, nicht mehr so effizient erfolgen, da die thermische Bewegung der Polymerketten und daher auch das Bestreben sich zu Entfalten, geringer ist. Der Hauptteil der Polymerkettenstreckung dürfte auf die externe Zugbelastung zurückführbar sein, sodass ein Einfluss auf die Sprödigkeit durch Temperaturerniedrigung als eher gering angesehen wird. Bei hohen Temperaturen tritt sogar ein inverser Effekt auf, bei dem die Polymerketten durch die Zufuhr von Wärme zusammengezogen werden. Dieser (unter dem Namen Entropieelastizität bekannte) Effekt begründet sich auf dem Bestreben der Polymerketten, ihre Entropie bei höheren Temperaturen zu maximieren. Diese Art der Sprödigkeit findet sich vor allem bei Elastomeren und Thermoplasten.

Alternativ oder zusätzlich ist Versprödung erfindungsgemäß insbesondere durch eine Abnahme der Duktilität durch Kristallisation des Polymers gekennzeichnet. Die meisten Polymere sind amorphe Festkörper. Der amorphe Zustand ist ein Resultat der relativ langen Polymerketten, die sich einerseits durch Seitengruppen verzweigen können, allerdings auch unterschiedliche Konformationen um die Verbindungslinien ihrer Bindungsachsen einnehmen können. Durch diese gewaltige Kombinationsmöglichkeit entstehen sehr kompliziert geformte, ineinander verkettete Polymerketten, die sich nur sehr schwer zueinander parallel und damit geordnet ausrichten. Die Fähigkeit einer Polymerkette, Teil eines teilkristallinen Bereichs zu werden sinkt offenbar mit der Komplexität, d.h. mit der Anzahl und/oder Länge Ihrer Verzweigungen, mit der Anzahl der Konformationsmöglichkeiten und der Fähigkeit, die Konformationen zu wechseln. Beispielsweise sind Moleküle um eine Doppel- oder Dreifachbindung rotationssteif, da die, sich überlagernden, π-Orbitale eine Rotation nicht ermöglichen. Dennoch können derartige Polymere zumindest teilkristallisiert werden. Die Kristallisation findet vorzugsweise durch Hinzugabe von Impfkeimen statt. Unter Impfkeimen versteht man, insbesondere feste, Körper, die in einem Kristallisationsmedium, insbesondere in einer Flüssigkeit oder in einem Feststoff, eine Kristallisation starten. Erfindungsgemäß können Polymeren Impfkeime hinzugesetzt werden, die eine Teilkristallisation des Polymers hervorrufen. Die Polymerisation erfolgt vorzugsweise unterhalb der kritischen Temperatur, sodass der Kleber erst unterhalb der kritischen Temperatur kristallisiert und eine entsprechende Sprödigkeit aufweist. Denkbar ist allerdings auch eine Kristallisation oberhalb der kritischen Temperatur.

Alternativ oder zusätzlich ist Versprödung erfindungsgemäß insbesondere durch eine Erzeugung von thermischen Spannungen und bei Überschreiten einer kritischen Spannung damit einhergehenden thermischen Rissen durch einen Thermoschock gekennzeichnet. Unter Thermoschock versteht man den physikalischen Effekt der ungleichmäßigen Temperaturbeaufschlagung eines rasch abgekühlten Körpers. Die ungleichmäßige Temperaturbeaufschlagung im Körper entsteht durch die endliche Wärmeleitfähigkeit des Körpers, welche dafür sorgt, dass der Wärmestrom nicht unendlich schnell aus dem Körper entweichen (bei Abkühlung) bzw. in den Körper eindringen (bei Erwärmen) kann. Der endliche Wert der thermischen Leitfähigkeit führt dazu, dass sich die Oberfläche eines rasch abgekühlten Körpers schneller an die Temperatur des ihn umgebenden Mediums angleicht, als die inneren Volumenschichten. Dementsprechend kommt es zu einem sehr starken Temperaturgradienten. Der Temperaturgradient führt zu einem starken Gradienten der thermischen Dehnung. Durch die Dehnungsunterschiede entlang des Gradienten entstehen sehr große thermische Spannungen. Überschreiten die thermischen Spannungen eine kritische Spannung, insbesondere die Bruchspannung des gekühlten Werkstoffes, kommt es zur Ausbildung von Rissen.

Die genannten Versprödungsarten haben insbesondere eine Auswirkung auf die Zerstörung der Verbindungsschicht durch Rissbildung. Durch das Anlegen einer externen mechanischen Belastung, insbesondere einer Zug- und/oder Biegebeanspruchung können sich Risse in der Verbindungsschicht bilden, die sich auf Grund der Sprödigkeit des Materials/Werkstoffes durch die Verbindungsschicht, insbesondere zwischen der Verbindungsschicht und der Substratoberfläche, überkritisch ausbreiten und damit zu einer, insbesondere automatisch/selbsttätig durch die Versprödung erfolgenden, Trennung der beiden Substrate voneinander führen. Durchläuft der Riss die Verbindungsschicht, verbleiben Reste der Verbindungsschicht an den Substratoberflächen beider Substrate. Im speziellen Fall, dass der überkritische Risswachstum zwischen der Verbindungsschicht und einer der beiden Substratoberflächen, in ganz speziellen Ausnahmefällen, an beiden Substratoberflächen, insbesondere durch Seitenwechsel des Risses, stattfindet, dürften Kleberreste hauptsächlich an einer der beiden Substratoberflächen nachweisbar sein.

Erfindungsgemäß ist Sprödigkeit insbesondere als ein Ablösungsphänomen zwischen der Verbindungsschicht und wenigstens einem der Substrate, hervorgerufen durch äußere Einflüsse, insbesondere durch Temperaturerniedrigung, gekennzeichnet.

Alternativ oder zusätzlich ist die Versprödung als ein Ablösungsphänomen zwischen Verbindungsschicht und wenigstens einem der Substrate auf Grund unterschiedlicher thermischen Ausdehnungskoeffizienten des Materials der Verbindungsschicht (oder des Materials einer Schicht der Verbindungsschicht) und des Substrats gekennzeichnet. Unterscheidet sich der thermische Ausdehnungskoeffizient der Verbindungsschicht von dem thermischen Ausdehnungskoeffizienten mindestens eines der beiden Substrate, so würden die Verbindungsschicht und die Substrate für sich gesehen (sofern sie voneinander getrennt wären) bei einer Abkühlung unterschiedliche thermische Dehnungen erfahren. Da die Verbindungsschicht und das Substrat an deren Oberfläche miteinander verbunden sind, wird die Schicht mit dem größeren thermischen Ausdehnungskoeffizienten bei einer Abkühlung dehnungsgehemmt. Die Dehnungshemmung führt zum Aufbau einer Zugeigenspannung. Diese Zugeigenspannung kann bei der Überschreitung eines kritischen Wertes zu einer Loslösung der Verbindungsschicht, insbesondere einer der Schichten der Verbindungsschicht, vom Substrat führen.

Soweit erfindungsgemäß ein Thermoplast als Material für die Verbindungsschicht verwendet wird, ist die Viskosität des Thermoplasts so groß, dass ein Abbau der auftretenden Eigenspannungen bei Überschreiten einer kritischen Differenz der Eigenspannungen ausschließlich durch einen Bruch, insbesondere entlang der Grenzfläche zwischen Verbindungsschicht und Substratoberfläche, abgebaut wird. Es erfolgt die erfindungsgemäße Trennung (Lösen).

Alternativ oder zusätzlich ist die Versprödung als ein Ablösephänomen zwischen der Verbindungsschicht und wenigstens einem der Substrate gekennzeichnet, das durch eine Volumenänderung der Verbindungsschicht bewirkt wird. Insbesondere wird durch die Volumenveränderung eine Änderung (bevorzugt Erhöhung) der Oberflächenrauhigkeit der Verbindungsschicht erzeugt. Die Verbindungsschicht wird vorzugsweise in einem flüssigen Zustand auf mindestens eines der beiden Substrate aufgebracht. Durch die entsprechend geringe Viskosität kann sich der Kleber optimal an die Substratoberfläche anpassen, die insbesondere eine extrem geringe Oberflächenrauhigkeit besitzen kann. Die Rauheit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich insbesondere bezogen auf dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen. Die Rauheit ist erfindungsgemäß insbesondere kleiner als 100 µm, vorzugsweise kleiner als 10 µm, noch bevorzugter kleiner als 1 µm, am bevorzugtesten kleiner als 100nm, am allerbevorzugtesten kleiner als 10nm.

Es hat sich erfindungsgemäß überraschend herausgestellt, dass die Volumenabnahme auf der Makroebene mehr oder weniger homogen und isotrop verläuft, während auf der Mikroebene, insbesondere an der Oberfläche der Verbindungsschicht eine Inhomogenität und/oder eine Anisotropie festzustellen ist. Diese Inhomogenität und/oder Anisotropie wird erfindungsgemäß dazu genutzt, dass die Verbindungsschicht ihr Volumen an unterschiedlichen Positionen unterschiedlich stark ändert. Dadurch entstehen eine Oberflächenrauhigkeit und damit eine Abnahme des Benetzungsgrades der Substratoberfläche durch die Verbindungsschicht. Einhergehend mit der Verringerung des Benetzungsgrades sinkt die Bondstärke zwischen den Oberflächen, was ein mechanisches Abziehen begünstigt und/oder im Idealfall zu einer spontanen Trennung des Substratstapels führt. Die Oberflächenrauhigkeit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen. Die durch die erfindungsgemäßen Ausführungsformen erzeugte Rauheit ist insbesondere größer als 1 nm, vorzugsweise größer als 10 nm, noch bevorzugter größer als 1 µm, am bevorzugtesten größer als 10 µm, am allerbevorzugtesten größer als 100 µm.

Insbesondere soll die Verbindungsschicht durch Temperaturerniedrigung versprödet werden. Die Versprödung der Verbindungsschicht wird erfindungsgemäß alternativ oder zusätzlich durch folgende Vorgänge bewirkt:
- Kühlung
- Additiventzug, insbesondere von
   ∘ Weichmachern, vorzugsweise durch
      □ Erwärmung und/oder
      □ Chemikalien (Lösungsmittel) und/oder
      □ elektrischen Strom und/oder
      □ Bestrahlung,
   ∘ Lösungsmittel vorzugsweise durch
      □ Erwärmung und/oder
      □ Bestrahlung,
- Härtung, insbesondere durch Bestrahlung, vorzugsweise UV-Bestrahlung.

Versprödung ist erfindungsgemäß insbesondere durch die Abnahme der plastischen Verformbarkeit der Verbindungsschicht gekennzeichnet. Ein ideal spröd brechender Werkstoff (oder Material) wird als ein Werkstoff bezeichnet, der bei angelegter mechanischer Belastung bricht, ohne sich vorher plastisch zu verformen. Die Sprödbrucheigenschaft des erfindungsgemäß für die Verbindungsschicht verwendeten Materials (insbesondere Kunststoff) kann erfindungsgemäß insbesondere durch Additive beeinflusst werden.

Die erfindungsgemäßen Ausführungsformen betreffen vor allem Vorrichtungen, mit denen die Temperatur der Verbindungsschicht eines Substratstapels effektiv auf einen zur Versprödung geeigneten Temperaturbereich erniedrigt werden kann. Es werden erfindungsgemäß Materialien für die Verbindungsschicht bevorzugt, deren Versprödung durch eine Temperaturerniedrigung erfolgt. Die Verbindungsschicht versprödet insbesondere bei Erreichen oder Unterschreiten eines kritischen Temperaturbereichs, insbesondere einer kritischen Temperatur. Die Unterscheidung zwischen einem kritischen Temperaturbereich und einer kritischen Temperatur beruht darauf, dass Sprödbruch meist nicht abrupt, sondern innerhalb eines Intervalls erfolgt. Insbesondere kann aber auch ein abrupter Übergang und/oder spröd-duktiler Übergang erfolgen, der dann mit einer kritischen Temperatur angegeben ist.

Der kritischen Temperaturbereich liegt erfindungsgemäß insbesondere zwischen 0°C und -50°C, vorzugsweise zwischen -25°C und -75°C, noch bevorzugter zwischen -50°C und -100°C, am bevorzugtesten zwischen -75°C und -125°C. Die kritische Temperatur ist insbesondere kleiner als 0°C, vorzugsweise kleiner als -50°C, noch bevorzugter kleiner als -100°C, am bevorzugtesten kleiner als -150°C. Werte für kritische Temperatur sollen auch als Werte für einen kritischen Temperaturbereich offenbart gelten. Die Begriffe sollen insbesondere jeweils den anderen Begriff mit umfassen.

Die Versprödung des erfindungsgemäß gewählten Materials kann reversibel oder (erfindungsgemäß bevorzugt) irreversibel sein. Die Versprödung ist reversibel, wenn Sie durch wiederholtes Abkühlen und aktives bzw. passives Aufheizen erzeugt bzw. aufgehoben werden kann. Es wird dabei ein Material für die Verbindungsschicht gewählt, das reversibel zwischen duktiler und spröder Eigenschaft wechseln kann. Die Versprödung ist irreversibel, wenn sie nicht mehr aufgehoben werden kann.

Soweit erfindungsgemäß eine reversible Versprödung erfolgt, wird das Lösen (Debondvorgang) erfindungsgemäß unterhalb der kritischen Temperatur durchgeführt.

Soweit erfindungsgemäß eine irreversible Versprödung erfolgt, wird das Lösen (Debondvorgang) insbesondere bei Raumtemperatur und/oder in einem räumlich getrennten Bereich, vorzugsweise einem Debonder, durchgeführt.

### Verspröder

Ein Verspröder ist eine Anlage/Vorrichtung, der mindestens aus einem Kühlkörper, insbesondere einer Kühlplatte mit einer, vorzugsweise einzigen, Kühlfläche, und mindestens einer Zuleitung besteht, über die ein Kühlfluid an den Kühlkörper, insbesondere an die Kühlfläche, herangeführt wird. Der Kühlkörper wird mit dem Kühlfluid beaufschlagt, insbesondere durchströmt, und dadurch wird Kühlleistung auf den Substratstapel und somit die Verbindungsschicht übertragen, die zu einer Abkühlung der Verbindungsschicht führen. Es wird insbesondere ein Kühlkörper gewählt, dessen spezifische Wärmekapazität so gering wie möglich ist, um eine Speicherung von Energie in Form von Wärme zu minimieren. Die spezifische Wärmekapazität des Kühlkörpers, insbesondere an seiner Kühlfläche, liegt zwischen 0.0 kJ/(kg*K) und 20 kJ/(kg*K), vorzugsweise zwischen 0.0 kJ/(kg*K) und 15 kJ/(kg*K), noch bevorzugter zwischen 0.0 kJ/(kg*K) und 10 kJ/(kg*K), am bevorzugtesten zwischen 0.0 kJ/(kg*K) und 5 kJ/(kg*K), am allerbevorzugtesten zwischen 0.0 kJ/(kg*K) und 1 kJ/(kg*K). Es wird insbesondere ein Kühlkörper gewählt, dessen Wärmeleitfähigkeit so groß wie möglich ist, um einen schnellen Abtransport der Wärme zu gewährleisten. Die Wärmeleitfähigkeit liegt vorzugsweise zwischen 0.1 W/(m*K) und 5000 W/(m*K), vorzugsweise zwischen 1 W/(m*K) und 2500 W/(m*K), noch bevorzugter zwischen 10 W/(m*K) und 1000 W/(m*K), am bevorzugtesten zwischen 100 W/(m*K) und 450 W/(m*K).

Das Kühlfluid wird gemäß einer vorteilhaften Ausführungsform über mindestens eine Zuleitung in oder an den Kühlkörper des Verspröders geleitet. Diese Ausführungsform kann weitergebildet werden, indem das Kühlfluid in mindestens einem (insbesondere der Anzahl der Zuleitungen entsprechenden) Kreislauf durch den Kühlkörper geleitet wird, um den Wärmeabtransport zu optimieren. Das Kühlfluid tritt vorzugsweise über eine zweite, von der Zuleitung unterschiedliche, Ableitung wieder aus dem Verspröder aus. Denkbar wäre auch die Verwendung mehrerer Zu- und/oder Ableitungen, insbesondere in Kombination mit einer Mischung unterschiedlicher Kühlfluide. Da die Trennung derartiger Fluide nach deren Vermischung in der Ausführungsform nicht möglich ist, werden vorzugsweise mehrere Zu- aber nur eine Ableitung an den Kühlkörper angeschlossen.

In einer weiteren Ausführungsform wird das Kühlfluid nicht ausschließlich durch den Kühlkörper geleitet, sondern tritt durch Öffnungen an der, insbesondere den Substratstapel berührenden, Unterseite des Kühlkörpers aus, um das Kühlfluid direkt auf die Oberfläche eines der beiden Substrate des Substratstapels zu leiten. Dadurch kommt es zu einem Direktkontakt des Kühlfluids mit dem Substrat des Substratstapels, was zu einer besseren Kühlung des Substrats, und damit des Klebers führt. Diese Ausführungsform eignet sich vor allem für verflüssigte Gase wie Helium oder Stickstoff, die bei direktem Kontakt mit dem Substrat diesem sehr rasch Wärme entziehen und dabei vorzugsweise in die Gasphase übergehen. Die entstandenen Gase können dann von dem zu kühlenden Substratstapel wegdiffundieren.

In einer weiteren Ausführungsform wird das Kühlfluid nicht in einem Kreislauf durch den Kühlkörper geleitet, sondern tritt ausschließlich durch Austrittsöffnungen aus dem Kühlkörper aus. Das erwärmte Kühlfluid entweicht insbesondere in einen Leerraum zwischen dem Kühlkörper und dem Substrat. Die Austrittsöffnungen wirken insbesondere als Ventile, bei der bevorzugten Verwendung von komprimierten Gasen als Drosselventile.

In einer weiteren Ausführungsform ist der Kühlkörper zumindest teilweise, vorzugsweise zumindest an einer, dem Substrat zugewandten Kühlfläche, porös. Kammern und/oder Kanäle des Kühlkörpers zur Aufnahme und/oder Verteilung des Kühlfluids sind Teile eines eigenständigen Behälters und/oder Leitungssystems und diese sind insbesondere aus einem nicht porösen, kompakten Material gefertigt. Dieser Behälter wird insbesondere zumindest teilweise, vorzugsweise an einer Austrittsöffnung, von einem porösen Körper umgeben. Denkbar wäre eine Einbettung des Behälters durch ein in Form gebrachtes Pulver, welches in einem Sinterprozess gesintert wird. Dadurch wird eine, insbesondere vollständige, Umschließung des Behälters durch ein poröses Material besonders vereinfacht. Vorzugsweise sind die Werkstoffeigenschaften, insbesondere die spezifischen Wärmekapazitäten und/oder die Wärmeleitfähigkeiten, des Behälters und des porösen Körpers weitestgehend gleich. Die Abweichungen der genannten Werkstoffeigenschaften sind bevorzugt kleiner als 20%, vorzugsweise kleiner als 10%, noch bevorzugter kleiner als 5%, am bevorzugtesten kleiner als 1%, am allerbevorzugtesten kleiner als 0.1%. Die spezifische Wärmekapazität des Behälters und/oder des porösen Körpers ist so gering wie möglich, um eine Speicherung von Energie in Form von Wärme zu unterbinden oder zu erschweren. Die spezifische Wärmekapazität liegt vorzugsweise zwischen 0.1 kJ/(kg*K) und 20 kJ/(kg*K), vorzugsweise zwischen 0.1 kJ/(kg*K) und 15 kJ/(kg*K), noch bevorzugter zwischen 0.1 kJ/(kg*K) und 10 kJ/(kg*K), am bevorzugtesten zwischen 0.1 kJ/(kg*K) und 5 kJ/(kg*K), am allerbevorzugtesten zwischen 0.1 kJ/(kg*K) und 1 kJ/(kg*K). Die Wärmeleitfähigkeit des Behälters und/oder des porösen Körpers ist so groß wie möglich, um einen schnellen Abtransport der Wärme zu gewährleisten. Die Wärmeleitfähigkeit liegt vorzugsweise zwischen 0.1 W/(m*K) und 5000 W/(m*K), vorzugsweise zwischen 1 W/(m*K) und 2500 W/(m*K), noch bevorzugter zwischen 10 W/(m*K) und 1000 W/(m*K), am bevorzugtesten zwischen 100 W/(m*K) und 450 W/(m*K).

Austrittslöcher aus dem Kühlkörper sind gemäß einer vorteilhaften Ausführungsform bevorzugt regelmäßig angeordnet. Diese können aber zumindest teilweise unregelmäßig verteilt sein.

Gemäß einem weiteren, insbesondere eigenständigen, Aspekt ist ein Probenhalter vorgesehen, der zur Aufnahme und Fixierung eines Substratstapels mit einem durch Temperaturabsenkung aktivierbaren Fixiermittel versehen ist. Insbesondere wird eine gefrierbare Flüssigkeit, vorzugsweise Wasser, verwendet, um die Haltefläche des Probenhalters zu besprühen. Während eines oben beschriebenen oder eines separaten Abkühlvorgangs friert die Flüssigkeit, insbesondere das Wasser, den Substratstapel am Probenhalter fest. Dadurch wird eine einfache Fixierung des Substratstapels am Probenhalter realisiert, ohne auf Klemmen, Vakuumbahnen, elektrostatische und/oder magnetische Elemente angewiesen zu sein. Durch die Fixierung kann insbesondere die Haltekraft zwischen dem Probenhalter und dem Substratstapel erhöht werden. Diese Ausführungsform kann daher auch in Verbindung mit anderen genannten Fixiervorrichtungen verwendet werden, eignet sich bevorzugt für eine vollflächige und/oder partielle Versprödung.

Gemäß einer vorteilhaften Ausführungsform wird der Substratstapel auf einer, insbesondere perforierten, Folie fixiert, um die Flüssigkeit, insbesondere das Wasser, auf einfache Art und Weise zum Substratstapel zu bringen. Das Wasser gefriert an der Folie, sowie an jenen Stellen des Substrats, die an den Perforationen liegen, an.

### Vollflächige Verspröder

In einer ersten Ausführungsform erfolgt die Versprödung zeitgleich vollflächig. Die zeitgleiche und vollflächige Versprödung erfolgt durch die, mindestens einseitige, Abkühlung des Substratstapels durch eine Vorrichtung, die eine Kühlfläche besitzt, die mindestens so groß ist wie die Fläche des zu kühlenden Substratstapels und damit des zu kühlenden Klebers. In einer ganz besonderen Ausführungsform erfolgt die Versprödung zeitgleich vollflächig und zweiseitig. Dadurch erfolgt eine Abkühlung von beiden Seiten des Substratstapels. Der Substratstapel wird dabei insbesondere symmetrisch gekühlt.

Die Kühlfläche entspricht vorzugsweise näherungsweise der Kühlkörperfläche. Die effektive Kühlfläche ist bevorzugt geringfügig kleiner, insbesondere wenn die Zuleitungen und Kühlkammern innerhalb des Kühlkörpers verlaufen. Vollflächige Verspröder können insbesondere im Gleichstromprinzip oder im Gegenstromprinzip betrieben werden, wobei das Gegenstromprinzip bevorzugt ist, da es eine effektivere Kühlung erlaubt.

### Partielle Verspröder

In einer zweiten Ausführungsform erfolgt die Versprödung durch mindestens einen Kühlkörper, deren Fläche kleiner ist als die Fläche des zu kühlenden Substratstapels. Die Fläche des Kühlkörpers ist insbesondere kleiner als 0.9 mal, vorzugsweise kleiner als 0.8 mal, noch bevorzugter kleiner als 0.6 mal, am bevorzugtesten kleiner als 0.4 mal, am allerbevorzugtesten kleiner als 0.2 mal der Fläche des Substratstapels. Der Kühlkörper wird relativ zu dem Substratstapel bewegt, um eine vollständige Kühlung und Versprödung der gesamten Verbindungsschicht zu gewährleisten. Die Relativbewegung erfolgt entweder durch die Bewegung des Kühlkörpers relativ zum statischen Substratstapel, durch Bewegung des Substratstapels relativ zum statischen Kühlköroper oder durch die Bewegung des Substratstapels und des Kühlkörpers.

In einer bevorzugten Ausführungsform ist der Kühlkörper statisch, während sich der Substratstapel bewegt. Durch diese Ausführungsform können mehrere Probleme gelöst werden. Erstens ist es nicht notwendig, die Leitungen zur Zuführung des Kühlfluids nachführbar zu konstruieren und auszuführen. Dadurch können diese kompakter konstruiert werden, da nachführbare Leitungen insbesondere dehnbar und/oder biegbar ausgestaltet sind. Auf Grund der niedrigen Temperaturen des zugeführten Kühlfluids wird das Leitungsmaterial so gewählt, dass es eine möglichst geringe Sprödbruchneigung aufweist und dadurch entsprechend widerstandsfähig ist.

### Periphere Verspröder

In einer dritten Ausführungsform erfolgt die Versprödung in einer, insbesondere vollumfänglichen, peripheren Region (also entlang einer seitlichen, ringförmigen Außenkontur) des Substratstapels. Vorzugsweise wird ein Klemmring gemäß der Druckschrift WO2012/139627A1 so weitergebildet, dass eine Kühlung des Klemmringes möglich wird. Der Klemmring wird dadurch zum Kühlkörper, wobei die Kühlung erfindungsgemäß auf die Peripherie des Substratstapels beschränkt wird. Der erfindungsgemäße Gedanke der WO2012/139627A1 bestand insbesondere darin, einen möglichst flexiblen und biegbaren Klemmring zu konstruieren. Um diese Eigenschaften nicht zu verlieren, kann der Klemmring so konstruiert werden, dass das Kühlfluid nicht durch den Klemmring strömt, sondern dieser von außen gekühlt wird. Dadurch muss der Klemmring konstruktionstechnisch nicht neu gestaltet werden und behält vor allem seine Flexibilität und Biegsamkeit. Nachteilig wäre die weniger effiziente Kühlung des Klemmrings im Vergleich zu einem vom Kühlfluid durchströmten Klemmring (bevorzugte Ausführungsform).

Der Klemmring kann auch ohne Kühlung verwendet werden, um eine Trennung eines bereits versprödeten Substratstapels durchzuführen. Dabei nutzt man insbesondere die mechanischen Eigenschaften, insbesondere die flexible Biegung des Klemmrings aus, um den bereits versprödeten Substratstapel peripher, insbesondere punktförmig, mit einer Kraft, insbesondere Zugkraft, zu belasten. Durch die, insbesondere punktförmige, Belastung wird eine besonders lokale konzentrierte Kraft, und damit eine hohe Zugspannung, erzeugt, die vor allem bei sprödbrechenden Materialien zum Versagen durch überkritisches Risswachstum führt.

### Verspröder als Debondprobenhalter

Alle genannten Ausführungsformen können bevorzugt so konstruiert sein, dass die Kühleinheiten, insbesondere die Kühlkörper auch als Probenhalter, insbesondere als Debondprobenhalter oder als Klemmring, ausgebildet sind.

Eine Fixierung eines Substrats, insbesondere eines Substrats als Teil des Substratstapels, erfolgt über Fixierelemente. Die Fixierelemente werden als
- mechanische Klemmen und/oder Vakuumbahnen und/oder
- elektrostatische Fixierung und/oder
- adhäsive, insbesondere schaltbare, Oberfläche und/oder
- magnetische und/oder
- elektrische Fixierung und/oder
- speziell geformte, vorzugsweise statische, Konstruktionselemente, wie insbesondere die Umfangsschulter und die Innenkante eines Klemmrings gemäß Druckschrift WO2012/139627A1.

Auf Grund der starken thermischen Belastung werden vorzugsweise mechanische Klemmen und/oder Vakuumbahnen verwendet.

Gemäß einer vorteilhaften Ausführungsform ist der Kühlkörper mit Austrittsöffnungen versehen und weist gleichzeitig Mittel zum Fixieren des Substratstapels und Absaugen von durch die Austrittsöffnungen austretendem Kühlfluid auf.

Zur vollflächigen Fixierung mittels Vakuum, eignet sich besonders bevorzugt die Ausführungsform des vollflächigen, porösen Verspröders, da eine Absaugung des Kühlfluids direkt über den porösen Kühlkörper erfolgen kann. Damit werden einerseits die durch den Verdampfungsprozess erzeugten Gase sofort abgesaugt und andererseits wird ein Unterdruck, insbesondere ein Vakuum, erzeugt. Der erzeugte Unterdruck ist stark genug für eine, insbesondere vollflächige, Fixierung eines Substrats.

In besonderen Ausführungsformen kann eine Verbesserung des Debondvorgangs durch die Beaufschlagung der Verbindungsschicht mit Ultraschall während und/oder nach der Versprödung erzielt werden. Die versprödete Verbindungsschicht, insbesondere Kleber, reagiert besonders empfindlich auf Wechselbeanspruchungen. Die Frequenz des Ultraschalls ist insbesondere größer als 1 Hz, vorzugsweise größer als 100 Hz, noch bevorzugter größer als 1 kHz, am bevorzugtesten größer als 1 MHz, am allerbevorzugtesten größer als 1 GHz. Der Ultraschall kann entweder auf einer Fläche wirken, die kleiner, gleich oder größer ist als die die Fläche des Substratstapels. Insbesondere können Ultraschallwellen in ein Kühlfluidbad eingekoppelt werden, vorzugsweise durch Anordnung eines Ultraschalgebers in dem Kühlfluid.

In einer ganz besonders bevorzugten Ausführungsform genügt bereits eine Einwirkung von Ultraschall auf den versprödeten Kleber, um eine Trennung der beiden Substrate zu bewerkstelligen.

### Versprödungsbäder

In einer weiteren Ausführungsform wird die Versprödung des Substratstapels, und damit des Klebers, in einem Versprödungsbad durchgeführt. Unter einem Versprödungsbad wird eine Ausführungsform verstanden, die zumindest aus einem Aufnahmebehälter, insbesondere einer Wanne, und dem darin befindlichen Kühlfluid besteht. Bei dem Kühlfluid handelt es sich vorzugsweise um flüssigen Stickstoff oder flüssiges Helium. Um das Kühlfluid an der vorzeitigen Verdampfung durch rasche Aufnahme von Wärme zu hindern, ist der Aufnahmebehälter vorzugsweise ein Dewargefäß.

In einer weiteren Ausführungsform befindet sich ein Probenhalter, insbesondere ein Podest, zur Aufnahme des Substratstapels innerhalb des Aufnahmebehälters. Die Ablagefläche des Probenhalters befindet sich vorzugsweise direkt unterhalb der höchsten Punkte der Aufnahmebehälterwand. In einer speziellen Ausführungsform befinden sich Ladevorrichtungen innerhalb des Probenhalters um einen Lade- bzw. Entladevorgang durchzuführen. Denkbar ist auch, dass der Probenhalter selbst die, insbesondere bewegbare, Ladevorrichtung darstellt. Der Probenhalter kann dann aus dem Aufnahmebehälter bewegt werden um den Substratstapel während eines Ladevorganges entgegenzunehmen bzw. nach einem erfindungsgemäßen Prozess wieder zur Entladung bereitzustellen.

In einer ganz besonders bevorzugten Ausführungsform sind Haltevorrichtungen außerhalb des Aufnahmebehälters vorgehsehen, die den Substratstapel bzw. den Rahmen mit Folie und Substratstapel fixieren. Dabei wird ein Absenken des Substratstapels bis zu einem Kühlniveau bewerkstelligt. Durch die kontrollierte Steuerung kann auf ein vollständiges Eintauchen des Substratstapels verzichtet werden.

Für die Vorrichtung und das erfindungsgemäße Verfahren sowie die Verwendung gelten die beschriebenen Merkmale analog.

Weitere Vorteile, Merkmale und Einzelheiten ergeben sich aus der Beschreibung bevorzugter Ausführungsbeispiele sowie anhand der Zeichnungen. Diese zeigen in:
- Figur 1a: eine schematische, nicht maßstabsgetreue Querschnittsdarstellung einer ersten Ausführungsform eines Substratstapels mit einer Verbindungsschicht,
- Figur 1b: eine schematische, nicht maßstabsgetreue Querschnittsdarstellung einer zweiten Ausführungsform des auf einer Folie angeordneten Substratstapels,
- Figur 1c: eine schematische, nicht maßstabsgetreue Querschnittsdarstellung einer dritten Ausführungsform des Substratstapels mit einer aus mehren Schichten bestehenden Verbindungsschicht,
- Figur 1d: eine schematische, nicht maßstabsgetreue Querschnittsdarstellung einer vierten Ausführungsform des Substratstapels,
- Figur 1e: eine schematische, nicht maßstabsgetreue Querschnittsdarstellung einer fünften Ausführungsform des Substratstapels mit einer eine strukturierte Schicht aufweisenden Verbindungsschicht,
- Figur 1f: eine schematische, nicht maßstabsgetreue Querschnittsdarstellung einer sechsten Ausführungsform des Substratstapels mit einer Verbindungsschicht bestehend aus einer Bondschicht und einer Trennschicht,
- Figur 2a: eine schematische, nicht maßstabsgetreue Querschnittsdarstellung einer ersten Ausführungsform einer Vorrichtung im Gegenstromprinzip,
- Figur 2b: eine schematische, nicht maßstabsgetreue Querschnittsdarstellung einer zweiten Ausführungsform der Vorrichtung im Gleichstromprinzip,
- Figur 3: eine schematische, nicht maßstabsgetreue Querschnittsdarstellung einer dritten Ausführungsform der Vorrichtung,
- Figur 4: eine schematische, nicht maßstabsgetreue Querschnittsdarstellung einer vierten Ausführungsform der Vorrichtung,
- Figur 5: eine schematische, nicht maßstabsgetreue Querschnittsdarstellung einer fünften Ausführungsform der Vorrichtung,
- Figur 6: eine schematische, nicht maßstabsgetreue Querschnittsdarstellung einer sechsten Ausführungsform der Vorrichtung,
- Figur 7: eine schematische, nicht maßstabsgetreue Querschnittsdarstellung einer siebten Ausführungsform der Vorrichtung,
- Figur 8: eine schematische, nicht maßstabsgetreue Querschnittsdarstellung einer achten Ausführungsform der Vorrichtung,
- Figur 9: eine schematische, nicht maßstabsgetreue Querschnittsdarstellung einer neunten Ausführungsform der Vorrichtung,
- Figur 10: eine schematische, nicht maßstabsgetreue Querschnittsdarstellung einer ersten Ausführungsform eines erfindungsgemäßen Debondprozesses,
- Figur 11: eine schematische, nicht maßstabsgetreue Querschnittsdarstellung einer zweiten Ausführungsform des erfindungsgemäßen Debondprozesses und

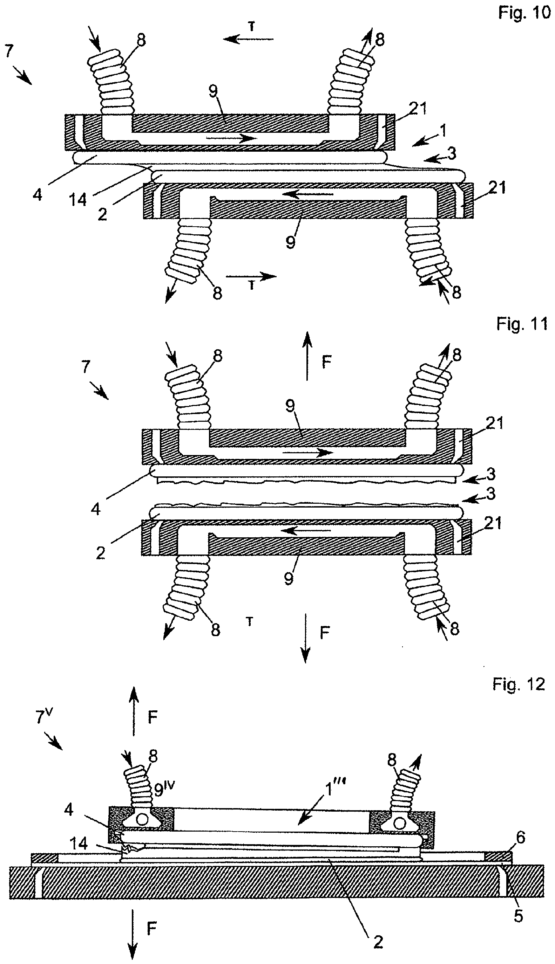

- Figur 11: eine schematische, nicht maßstabsgetreue Querschnittsdarstellung einer dritten Ausführungsform des erfindungsgemäßen Debondprozesses.

In den Figuren sind gleiche Bauteile oder Bauteile mit der gleichen Funktion mit den gleichen Bezugszeichen gekennzeichnet.

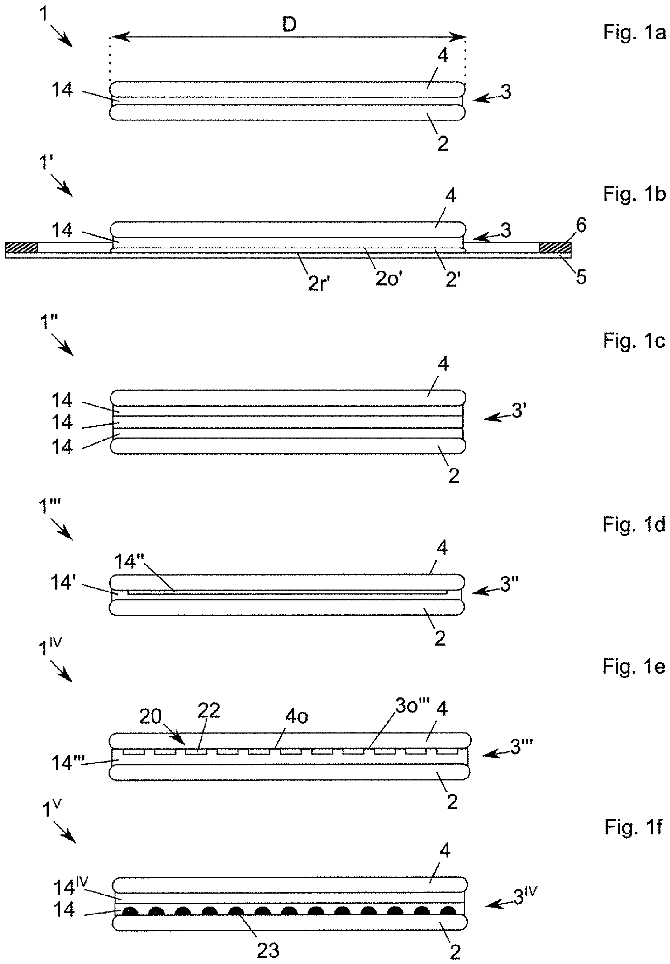

Figuren 1a, 1b, 1c, 1d und 1e zeigen Substratstapel 1, 1', 1", 1''', 1^{IV}, jeweils bestehend aus einem als Produktsubstrat ausgebildeten ersten Substrat 2, 2', einer als Kleber ausgebildeten Verbindungsschicht 3, 3', 3", 3''' und einem als Trägersubstrat ausgebildeten zweiten Substrat 4. Die Verbindungsschicht 3, 3', 3", 3''' verbindet das erste Substrat 2, 2' mit dem zweiten Substrat 4. Die Substrate 2, 2', 4 weisen einen Durchmesser D auf.

Die Verbindungsschicht 3 besteht bei der ersten Ausführungsform gemäß Figur 1a aus einer einzigen, als Einkomponentensystem oder Mehrkomponentensystem ausgebildeten, Schicht.

Bei der zweiten Ausführungsform gemäß Figur 1b weist der Substratstapel 1' ein, insbesondere rückgedünntes, Produktsubstrat 2' aus, das über seine nicht rückgedünnte Oberfläche 2o' durch die Verbindungsschicht 3 an dem Trägersubstrat 4 fixiert wurde. Eine rückgedünnte Seite 2r' ist an einer Folie 5, insbesondere einer Trennfolie (engl.: dicing tape), fixiert. Die Folie 5 ist auf einem Trägerrahmen 6 (engl.: frame) aufgespannt.

Der Substratstapel 1" gemäß Figur 1c besteht aus dem Produktsubstrat 2, das über die, insbesondere aus mehreren Schichten 14 bestehende, Verbindungsschicht 3' mit dem Trägersubstrat 4 fixiert ist. Jede der Schichten 14 kann aus einer einzigen oder aus mehreren Komponenten bestehen. Insbesondere müssen nicht alle der Schichten 14 klebende Schichten sein.

Bei der Ausführungsform gemäß Figur 1d ist der Substratstapel 1''' mit einer als ZoneBOND™-System ausgebildeten Verbindungsschicht 3" ausgestattet. Die Verbindungsschicht 3" weist eine klebende Schicht 14" auf, die sich über die gesamte Kontaktfläche zwischen den beiden Substraten 2, 4 erstreckt. Eine haftreduzierte Schicht 14" bedeckt eine der Oberflächen der Verbindungsschicht 3", so dass die Verbindungskraft zumindest überwiegend, vorzugsweise praktisch ausschließlich an einem die haftreduzierte Schicht 14" umgebenden äußeren Ringabschnitt wirkt.

Bei der Ausführungsform gemäß Figur le besteht der Substratstapel 1^{IV} aus dem Produktsubstrat 2, das über die Verbindungsschicht 3''' mit dem Trägersubstrat 4 fixiert ist. Die Verbindungsschicht 3''' ist aus einer strukturierten Schicht 14''' gebildet. Die Ausführungsform sieht vor, die Schicht 14''' zu strukturieren. Durch die Strukturierung werden Kavitäten 20 gebildet, in denen ein Füllmaterial 22 aufgenommen werden kann. Die Strukturierung erfolgt durch einen bekannten Prozess, insbesondere durch Imprint- oder Photolithographie. Durch die Ausführungsform erhält man eine gemusterte Kleberoberfläche 3o''', die durch einen der erfindungsgemäßen Versprödungsvorgänge eine Erniedrigung der Adhäsionskraft zwischen der Kleberoberfläche 3o''' und der Trägersubstratoberfläche 4o bewirkt. Insbesondere verringert das in den Kavitäten 20 abgeschiedene Füllmaterial 22 durch die Temperaturerniedrigung sein Volumen derart, dass die effektive Haftfläche zwischen dem Kleber 3, 3', 3", 3''' und dem Trägersubstrat 4 verkleinert wird. Die strukturierte Schicht 14''' kann gemäß einer alternativen Ausführung auch Teil eines Mehrschichtsystems sein und daher von einer anderen genannten Schicht 14 bedeckt werden. Bei der Ausführungsform gemäß Figur 1f besteht der Substratstapel 1^{V} aus dem Produktsubstrat 2 mit Topographien, insbesondere Lotkugeln (engl.: bumps), 23. Das Produktsubstrat ist über die Verbindungsschicht 3^{IV} mit dem Trägersubstrat 4 fixiert. Die Verbindungsschicht 3^{IV} besteht aus einer Kleberschicht 14 und einer Trennschicht 14^{IV}. Die Kleberschicht 14 dient insbesondere zur Einbettung der Topographien 23 des Produktsubstrats 2.

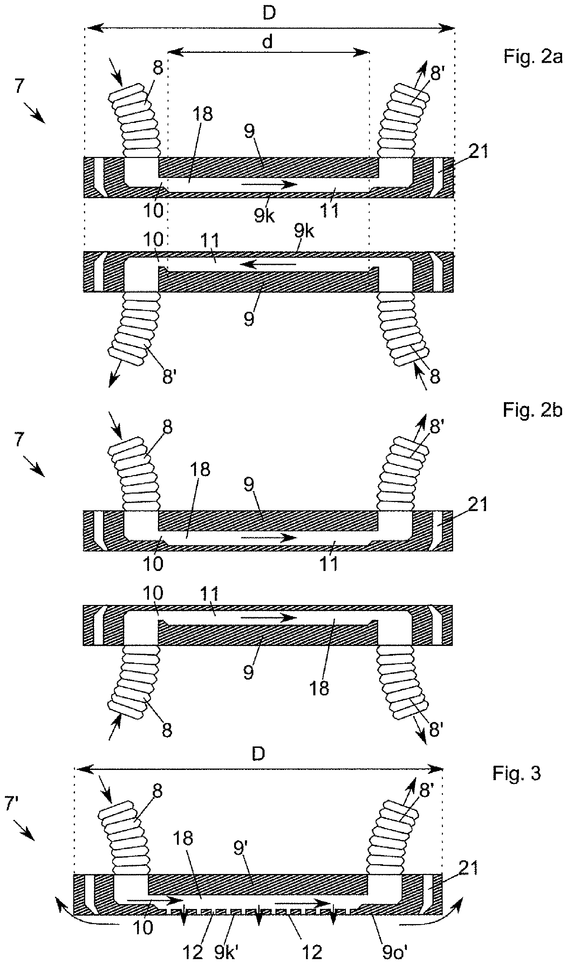

Figur 2a zeigt eine schematische, nicht maßstabsgetreue
Querschnittsdarstellung einer vereinfachten, ersten Ausführungsform einer Kühleinheit 7, die im Gegenstromprinzip betrieben wird. Die erfindungsgemäße Kühleinheit 7 besteht dabei aus mindestens einem, vorzugsweise genau zwei, Kühlkörpern 9 mit einer Kühlfläche 9k. Die Kühlkörper 9 besitzen Kanäle 10 und/oder Kammern 11, die über, insbesondere nachführbare, als Zu- und Ableitung ausgebildete Leitungen 8, 8' mit einem Kühlfluid 18, insbesondere einer Kühlflüssigkeit, noch bevorzugter einem Kühlgas, versorgt werden. Um einen effizienten Abtransport von an der Kühlfläche 9k aufgenommener Wärme zu gewährleisten, wird die Ausführungsform bevorzugt im Gegenstrom betrieben. Die beiden, durch die Kanäle 10 und/oder Kammern 11 der Kühlkörper 9 strömenden Kühlfluide besitzen dabei antiparallele bzw. gegengleiche Strömungsvektoren.

Die Substrate 2 und/oder 4 sind durch die Fixierelemente 21, insbesondere Vakuumbahnen, an den, vorzugsweise als Probenhalter ausgebildeten Kühleinheiten 7, 7', 7", fixierbar. Die Fixierung erfolgt vor und/oder während und/oder nach einer Versprödung zum Debonden der Substrate 2, 4. Bei der Ausführungsform gemäß Figur 2b arbeiten die Kühleinheiten 7 im Gleichstromprinzip. Die beiden, durch die Kanäle 10 und/oder Kammern 11 der Kühlkörper 9 strömenden Kühlfluide 18 besitzen dabei parallele bzw. gleichgerichtete Strömungsvektoren.

Figur 3 zeigt eine Kühleinheit 7', bestehend aus einem Kühlkörper 9', zwei als Zu- und Ableitung ausgebildeten Leitungen 8, 8', die als Zu- bzw. Abfluss dienen, sowie mehreren entlang der Kühlfläche 9k' verteilten Austrittsöffnungen 12, die einen Austritt des Kühlfluids 18 über eine dem Substratstapel 1, 1', 1", 1''', 1^{IV} zugewandte Kühlkörperoberfläche 9o' erlauben.

Der Kühlkörper 9' wird durch das in den Kanälen 10 und/oder der Kammer 11 strömende, insbesondere zirkulierende, Kühlfluid 18 gekühlt. Gleichzeitig tritt ein Teil des Kühlfluids 18 aus den Öffnungen 12 aus und führt zu einer zusätzlichen, intensiveren Kühlung des Substratstapels 1, 1', 1", 1''', 1^{IV}. Das ausgetretene, insbesondere durch den Substratstapel 1, 1', 1", 1''', 1^{IV} erwärmte und in die Gasphase übergetretene, Kühlfluid 18 wird entlang der Kühlkörperoberfläche 9o' abgeführt.

Zur Überwachung des Abkühlvorgangs wird gemäß einer Weiterbildung der vorliegenden Erfindung eine Messung, der über den Kühlkörper und das Kühlfluid 18 aufgenommenen Wärmemenge durch eine Temperaturvergleichsmessung durchgeführt.

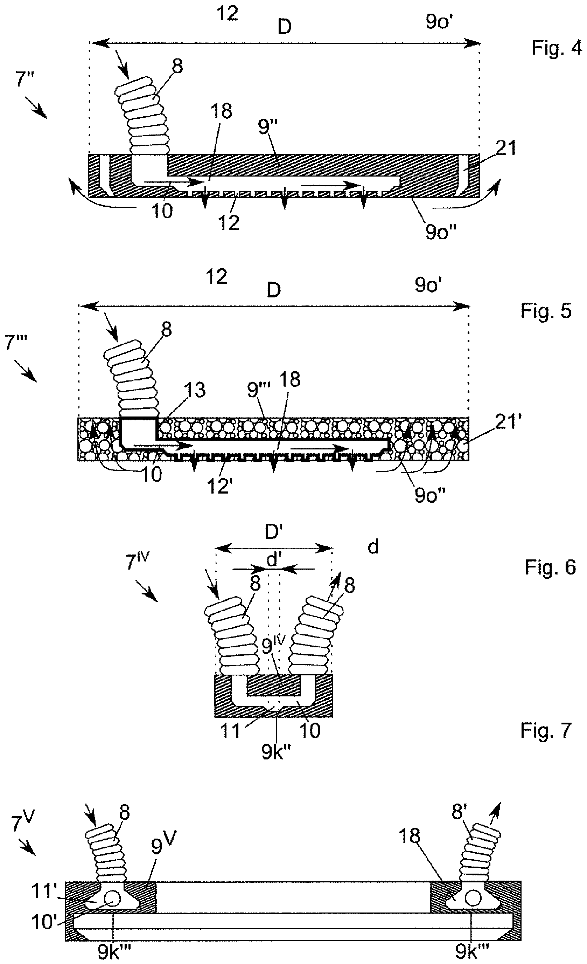

Figur 4 zeigt eine Kühleinheit 7", bestehend aus einem Kühlkörper 9", einer als Zuleitung ausgebildeten Leitung 8 sowie mehreren Austrittsöffnungen 12, die einen Austritt des Kühlfluids 18 über die Kühlkörperoberfläche 9o" erlauben.

Der Kühlkörper 9" wird durch das in den Kanälen 10 und/oder der Kammer 11 strömende Kühlfluid 18 gekühlt. Gleichzeitig tritt ein Teil des Kühlfluids 18 aus den Austrittsöffnungen 12 aus und führt zu einer zusätzlichen, intensiveren Kühlung des Substratstapels 1, 1', 1 ", 1''', 1^{IV}. Das ausgetretene, insbesondere durch den Substratstapel 1, 1', 1", 1''', 1^{IV} erwärmte und in die Gasphase übergetretene, Kühlfluid 18 wird entlang der Kühlkörperoberfläche 9o" abgeführt.

Durch eine Steuerung (mittels einer nicht dargestellten Steuerungseinrichtung, die für die Steuerung der beschriebenen Prozesse und Bauteile und Betriebsmittel zuständig ist) des Kühlfluiddrucks kann insbesondere die Austrittsgeschwindigkeit und der Austrittsdruck des Kühlfluids 18 an den Austrittsöffnungen 12 reguliert werden.

Der Kühlkörper 9" ist bevorzugt als ein aus mehreren Austrittsöffnungen 12 bestehendes Drosselventil ausgebildet. Durch ein entsprechend vorkomprimiertes Kühlfluid 18 kann (sofern das Kühlfluid 18 sich im korrekten Temperaturbereich befindet und einen positiven Joule-Thomson-Koeffizient besitzt) eine bevorzugte isenthalpische Expansion des Kühlfluids 18 und damit eine weitere Abkühlung des Gases erfolgen. Die Austrittsöffnungen 12 dienen dabei als Drosselventile, der Kühlkörper 9" als Isolation.

In einer ganz besonders bevorzugten Ausführungsform wird reine Luft als Kühlfluid 18 aus der Umgebung durch Kompressoren auf mehr als 20 bar, insbesondere mehr als 50 bar, noch bevorzugter mehr als 100 bar, am bevorzugtesten mehr als 150 bar, am allerbevorzugtesten mehr als 200 bar komprimiert. Durch isenthalpische Expansion der Luft auf einen Druck von weniger als 100 bar, insbesondere weniger als 50 bar, noch bevorzugter weniger als 25 bar, am bevorzugtesten weniger als 10 bar, am allerbevorzugtesten weniger als 5 bar sind bereits Temperaturerniedrigungen von mehren Grad Celsius möglich. Insbesondere wird durch eine derartige isenthalphische Expansion eine Temperaturerniedrigung von mehr als 5 °C, insbesondere mehr als 10 °C, noch bevorzugter mehr als 25 °C, am bevorzugtesten mehr als 35 °C, am allerbevorzugtesten mehr als 45 °C erreicht. Diese Temperaturabnahmen können bereits den Effekt der Versprödung bewerkstelligen, sofern das Material der Verbindungsschicht auf den entsprechenden Temperaturbereich ausgelegt ist.

Figur 5 zeigt eine Kühleinheit 7''', bestehend aus einem als poröser Körper ausgebildeten Fixierelement 21', das einerseits zur Fixierung des Substratstapels 1, 1', 1", 1''', 1^{IV}, 1^{V} mittels Unterdruck und andererseits zur Absaugung des aus den Austrittsöffnungen ausgetretenen Kühlfluids 18 dient. Weiterhin weist die Kühleinheit 7''' einen, insbesondere in das Fixierelement 21' eingebetteten, insbesondere aus einem nicht porösen und/oder andersartigen Material bestehenden, Behälter 13 mit einer Zuleitung 8 sowie mehreren Austrittsöffnungen 12'.

Die Austrittsöffnungen 12' sind Ausgänge des Behälters 13. Ein Aspekt besteht in der Zuleitung eines Kühlfluids 18 über die Zuleitung 8 in den Behälter 13 und Austritt des Kühlfluids 18 aus den Austrittsöffnungen. Anschließend erfolgt eine Absaugung des, insbesondere in den gasförmigen Aggregatzustand übergegangenen, Kühlfluids 18 über den porösen Kühlkörper 9'''.Die Kühlung erfolgt bei dieser bevorzugten Ausführungsform überwiegend durch das aus den Austrittsöffnungen 12' direkt zum Substratstapel geleitete Kühlfluid 18.

Diese Ausführungsform eignet sich somit insbesondere als Kühlprobenhalter, der durch das Anlegen eines Vakuums über die Porosität des Kühlkörpers 9''' gleichzeitig über eine Fixiermöglichkeit für das Debonden verfügt.

Der poröse Körper 21' wird gemäß einer Weiterbildung der Erfindung seitlich durch konstruktionstechnische Maßnahmen vakuumdicht ausgebildet. Insbesondere wird der poröse Körper 21' in ein, den porösen Körper umschließendes Bauteil (nicht eingezeichnet) eingesetzt, sodass an den Seiten des Kühlkörpers 9''' kein Vakuumleck entsteht.

Figur 6 zeigt eine aus einem Kühlkörper 9^{IV} bestehende Kühleinheit 7^{IV}, dessen Durchmesser D' oder der Durchmesser d' dessen Kühlfläche 9k" kleiner ist als der Durchmesser D mindestens eines der Substrate 2, 2', 4. Durch diese Maßnahme wird ein Kühlkörper 9^{IV} bereitgestellt, mit dem durch eine Relativbewegung zu einem Substratstapel 1, 1', 1", 1''', 1^{IV} eine sequentielle Versprödung der Verbindungsschicht 3, 3', 3", 3''' erfolgen kann. Eine derartige Ausführungsform ist vorteilhaft für Substratstapels 1, 1', 1", 1''', 1^{IV}, deren Verbindungsschicht 3, 3', 3", 3''' ausschließlich an Teilen der Kontaktfläche zwischen den Substraten 2, 4, insbesondere an der äußeren Peripherie, verbondet ist, während andere Abschnitte nicht oder nur mit geringer Adhäsionskraft verbunden sind.

Derartige Kühlkörper 7^{IV} können vorteilhafterweise zur Versprödung eines ZoneBOND™-Substratstapels gemäß Figur 1d verwendet werden, ohne die zentrale Region des Substratstapels 1''' übermäßig thermisch zu belasten.

Figur 7 zeigt eine Kühleinheit 7^{V}, die einen ringförmigen Kühlkörper 9^{V} besitzt. Der ringförmige Kühlkörper 9^{V} stellt eine Verbesserung der Ausführungsform in der Druckschrift WO2012/139627A1 dar. Die ringförmige Ausführungsform des Kühlkörpers 9^{V} erlaubt insbesondere ein vollumfängliche, aber auf die äußere Peripherie eines Substratstapels 1''' beschränkte Kühlung, sowie vorzugsweise eine gleichzeitige Abhebung (Lösen) des Trägersubstrats 4 nach der erfindungsgemäßen Versprödung.

Der Kühlköper 9^{V} weist mindestens eine als Zuleitung ausgebildete Leitung 8 und mindestens eine, insbesondere gegenüberliegend angeordnete, als Ableitung ausgebildete Leitung 8' auf. Über einen ringförmigen Kanal 10' wird das Kühlfluid 18 von der Zuleitung in mindestens eine Kammer 11' zu einer Kühlfläche 9k'''geleitet.

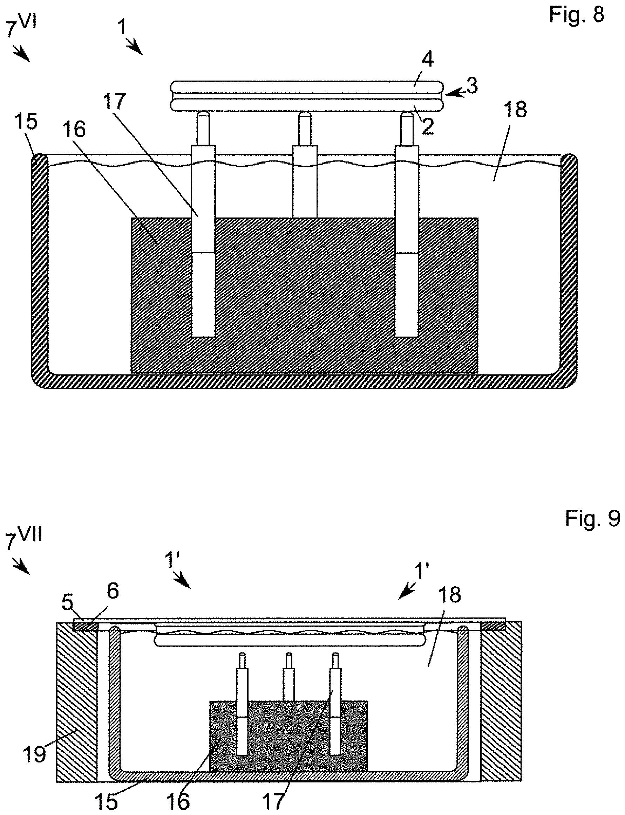

Figur 8 zeigt eine Kühleinheit 7^{VI}, die einen Aufnahmebehälter 15 aufweist, in dem das Kühlfluid 18 gelagert wird. Innerhalb der Aufnahmebehälters 15 befindet sich ein Probenhalter 16, auf dem ein Substratstapel 1 abgelegt werden kann, um vollständig in das Kühlfluid 18 eingetaucht zu werden. Vorzugsweise weist der Probenhalter 16 hierzu Ladeeinheiten 17 auf, mit welchen ein Be- und Entladen des Substratstapels 1, 1', 1", 1''', 1^{IV} ermöglicht wird.

Die Ladeeinheiten 17 sind gegen den Probenhalter 16 mittels Dichtungen (nicht dargestellt) abgedichtet.

Alternativ kann der Probenhalter 16 selbst als bewegbare Ladeeinheit ausgebildet sein.

Diese Ausführungsform erlaubt ein automatisiertes Be- und Entladen des Substratstapels 1, 1', 1", 1''', 1^{IV} durch einen Roboter. Die Steuerung erfolgt über die Steuerungseinrichtung.

Figur 9 zeigt eine Kühleinheit 7^{VII}, die neben dem Aufnahmebehälter 15 und dem Probenhalter 16 einen, insbesondere außerhalb des Aufnahmebehälters 15 angeordneten Rahmenhalter 19 aufweist. Der auf einer Folie 5 fixierte Substratstapel 1' taucht in das Kühlfluid 18 ein, während der Rahmen 6 durch den, insbesondere separat bewegbaren und steuerbaren, Rahmenhalter 19 fixiert wird.

Der Rahmenhalter 19 kann sich außerhalb oder innerhalb des Aufnahmebehälters 15 befinden. Durch eine Aufnahme des Rahmenhalters 19 in den Aufnahmebehälter 15 wäre eine vollständige Aufnahme des Substratstapels 1' in das Kühlfluid 18 möglich.

Figur 10 zeigt einen ersten erfindungsgemäßen Debondprozess (Verfahren zum Lösen), bei dem die Kühleinheit 7, 7', 7", 7''', 7^{IV} im Gegenstromprinzip zum Kühlen des Substratstapels 1, 1', 1", 1''', 1^{IV} verwendet wird und gleichzeitig als Debonderprobenhalter dient. Die beiden Substrate 2 und 4 werden durch jeweils einen Kühlkörper 9, der gleichzeitig ein Debonderprobenhalter ist, durch eine Scherbeanspruchung τ voneinander getrennt.

Die Versprödung der Verbindungsschicht 3, 3', 3", 3''' erfolgt kurz vor (bevorzugt) und/oder während des Debondens. Die Substrate 2 und 4 werden zumindest beim Lösen/Debonden durch die Fixierelemente 21, insbesondere Vakuumbahnen, fixiert.

Figur 11 zeigt einen zweiten erfindungsgemäßen Debondprozess, bei dem eine Kühleinheit 7 im Gegenstromprinzip zum Kühlen des Substratstapels 1, 1', 1", 1''', 1^{IV} herangezogen wird und gleichzeitig als Debonderprobenhalter dient. Die beiden Substrate 2 und 4 werden durch jeweils einen Kühlkörper 9, der gleichzeitig ein Debonderprobenhalter ist, durch eine Zugbeanspruchung F voneinander getrennt. Die Versprödung des Klebers 3, 3', 3", 3''' erfolgt kurz vor (bevorzugt) und/oder während des Debondens. Die Substrate 2 und 4 werden durch die Fixierelemente 21, insbesondere Vakuumbahnen, fixiert.

Durch die erfindungsgemäße Ausführungsform könnte es erstmals möglich sein, einen Substratstapel 1, dessen Substrate 2 und 4 durch einen Kleber 3, 3', 3", 3''' vollflächig miteinander verbondet wurden, durch eine Normalkraft an der gesamten Kontaktfläche der Substrate 2, 4 gleichzeitig, insbesondere ohne Verformung der Substrate 2, 4, voneinander zu trennen.

Figur 12 zeigt einen dritten erfindungsgemäßen Debondprozess, bei dem die Kühleinheit 7^{V} zum Kühlen der Peripherie des Substratstapels 1''' herangezogen wird und gleichzeitig als Klemmring für das Trägersubstrat dient. Die beiden Substrate 2 und 4 werden durch eine an der Peripherie, insbesondere vollumfänglich, angelegte Zugbeanspruchung F voneinander getrennt, die zu einer Biegung des Trägersubstrats 4 führt. Die Versprödung des Klebers 3, 3', 3", 3''' erfolgt kurz vor und/oder während des Debondens. Das Produktsubstrat wird über die Folie 5 an einem unteren Probenhalter 16 fixiert, der vorzugsweise über Fixierelemente 21 verfügt.

### Bezugszeichenliste

- 1, 1', 1", 1"', 1^{IV}, 1^{V}: Substratstapel
- 2, 2': Produktsubstrat
- 2o': Produktsubstratoberfläche
- 2r': rückgedünnte Produktsubstratoberfläche
- 3, 3', 3", 3"',3^{IV}: Verbindungsschicht, insbesondere Kleber
- 3o"': Kleberoberfläche
- 4: Trägersubstrat
- 4o: Trägersubstratoberfläche
- 5: Folie
- 6: Rahmen
- 7, 7', 7", 7"', 7^{IV}, 7^{V}, 7^{VI}: Kühleinheit
- 8, 8': Leitungen
- 9, 9', 9", 9"', 9^{IV}, 9^{V}: Kühlkörper, insbesondere Kühlplatte
- 9o', 9o": Kühlkörperoberfläche
- 9, 9k', 9k", 9k"': Kühlfläche
- 10: Kanal
- 11: Kammer
- 12, 12': Öffnung
- 13: Behälter
- 14, 14', 14", 14"', 14^{IV}: Schicht
- 15: Aufnahmebehälter
- 16: Probenhalter
- 17: Ladeeinheiten
- 18: Kühlfluid
- 19: Rahmenhalter
- 20: Kavität
- 21, 21': Fixierelemente, insbesondere Vakuumbahnen
- 22: Füllmaterial
- 23: Topographie
- D, D': Durchmesser
- d, d': Durchmesser effektive Kühlfläche
- F: Normalkraft
- τ: Scherkraft

## Patentansprüche

1. Verfahren zum Lösen eines mit einem zweiten Substrat (4) durch eine Verbindungsschicht (3, 3', 3", 3''', 3^{IV}) verbundenen ersten Substrats (2) von dem zweiten Substrat (4) durch Versprödung der Verbindungsschicht (3, 3', 3", 3''', 3^{IV}), wobei die Versprödung durch Abkühlung auf eine Temperatur unter 0°C erfolgt, wobei zur Versprödung ein Kühlfluid (18) verwendet wird, mit dem die Verbindungsschicht (3, 3', 3", 3''', 3^{IV}) abgekühlt wird, wobei der gesamte Substratstapel (1, 1', 1", 1''', 1^{IV}, 1^{V}) abgekühlt wird, um die Verbindungsschicht (3, 3', 3", 3''', 3^{IV}) zu verspröden.

2. Verfahren nach Anspruch 1, bei dem die Versprödung durch Abkühlung auf eine Temperatur unter -100°C, noch bevorzugter unter -150°C, erfolgt.

3. Verfahren nach Anspruch 1 oder 2, bei dem die Verbindungsschicht (3, 3', 3", 3''', 3^{IV}) aus einem der nachfolgenden Materialien gewählt wird:
• Silikone,
• Kunststoffe, insbesondere
∘ Thermoplaste,
∘ Duroplaste,
∘ Elastomere oder
• Wachse.

4. Verfahren nach Anspruch 1 oder 2, bei dem die Verbindungsschicht (3, 3', 3", 3''') aus einem oder mehreren der nachfolgenden Materialien gewählt wird:
• Organische Komponenten, insbesondere organische Moleküle und/oder
• Anorganische Komponenten, insbesondere anorganische Moleküle und/oder
• Metalle, insbesondere Metallionen und/oder
• Metalllegierungen und/oder
• Keramiken.

5. Verfahren nach einem der vorhergehenden Ansprüche, bei dem zum Verspröden, insbesondere Abkühlen, ein, insbesondere von dem Kühlfluid (18) durchströmter, Kühlkörper (9, 9', 9", 9''', 9^{IV}, 9^{V}) mit einer Kühlfläche (9, 9k', 9k", 9k''') verwendet wird, wobei die Kühlfläche insbesondere eine Wärmeleitfähigkeit zwischen 0.1 W/(m*K) und 5000 W/(m*K), vorzugsweise zwischen 1 W/(m*K) und 2500 W/(m*K), noch bevorzugter zwischen 10 W/(m*K) und 1000 W/(m*K), am bevorzugtesten zwischen 100 W/(m*K) und 450 W/(m*K) aufweist.

6. Verfahren nach einem der vorhergehenden Ansprüche, bei dem ein, insbesondere den Kühlkörper (9, 9', 9", 9''', 9^{IV}, 9^{V}) aufweisender, erster Probenhalter zur Halterung des ersten Substrats und/oder ein, insbesondere den Kühlkörper (9, 9', 9", 9''', 9^{IV}, 9^{V}) aufweisender, zweiter Probenhalter zur Halterung des zweiten Substrats beim Lösen verwendet wird/werden.

7. Verfahren nach einem der vorhergehenden Ansprüche, dadurch charakterisiert dass die Verbindungsschicht (3, 3', 3", 3''', 3^{IV}) während und/oder nach der Abkühlung und/oder Versprödung mit Ultraschall beaufschlagt wird.

## Claims

1. A method for detaching a first substrate (2) which is connected to a second substrate (4) by an interconnect layer (3, 3', 3", 3''', 3^{IV}) from the second substrate (4) by embrittlement of the interconnect layer (3, 3', 3", 3''', 3^{IV}), wherein the embrittlement takes place by cooling to a temperature below 0°C, wherein a cooling fluid (18) with which the interconnect layer (3, 3', 3", 3''', 3^{IV}) is cooled is used for embrittlement, wherein the whole substrate stack (1, 1', 1", 1''', 1^{IV}, 1^{V}) is cooled in order to embrittle the interconnect layer (3, 3', 3", 3''', 3^{IV}).

2. The method as claimed in Claim 1, wherein the embrittlement takes place by cooling to a temperature below -100°C, still more preferably below -150°C.

3. The method as claimed in Claim 1 or 2, wherein the interconnect layer (3, 3', 3", 3''', 3^{IV}) is chosen from one of the following materials:
- silicones and/or
- plastics, in particular
- thermoplastics,
- duroplastics,
- elastomers,
- wax.

4. The method as claimed in Claim 1 or 2, wherein the interconnect layer (3, 3', 3", 3''') is chosen from one or more of the following materials:
- organic components, especially organic molecules, and/or
- inorganic components, especially inorganic molecules and/or
- metals, in particular metal ions and/or
- metal alloys and/or
- ceramics.

5. The method as claimed in one of the preceding claims, wherein
a cooling body (9, 9', 9", 9''', 9^{IV}, 9^{V}) through which in particular a cooling fluid (18) flows with a cooling area (9, 9k', 9k", 9k"') is used for embrittlement, in particular cooling, the cooling area having in particular a thermal conductivity between 0.1 W/(m*K) and 5000 W/(m*K), preferably between 1 W/(m*K) and 2500 W/(m*K), still more preferably between 10 W/(m*K) and 1000 W/(m*K), most preferably between 100 W/(m*K) and 450 W/(m*K).

6. The method as claimed in one of the preceding claims, wherein a first wafer chuck which has in particular the cooling body (9, 9', 9", 9''', 9^{IV}, 9^{V}) is used to hold the first substrate and/or a second wafer chuck which has in particular the cooling body (9, 9', 9", 9''', 9^{IV}, 9^{V}) is used to hold the second substrate during detachment.

7. The method as claimed in one of the preceding claims, **characterized in that** the interconnect layer (3, 3', 3", 3"', 3^{IV}) is exposed to ultrasound during and/or after cooling and/or embrittlement.

## Revendications

1. Procédé destiné à la séparation d'un premier substrat (2) relié à un second substrat (4) par une couche de liaison (3, 3', 3", 3''', 3^{IV}), du second substrat (4) par fragilisation de la couche de liaison (3, 3', 3", 3''', 3^{IV}), dans lequel la fragilisation est effectuée par refroidissement à une température inférieure à 0°C, dans lequel pour fragiliser, un fluide réfrigérant (18) est employé avec lequel la couche de liaison (3, 3', 3", 3''', 3^{IV}) est refroidie, dans lequel la pile de substrats (1, 1', 1", 1''', 1^{IV}, 1^{V}) totale est refroidie pour fragiliser la couche de liaison (3, 3', 3", 3''', 3^{IV}).

2. Procédé selon la revendication 1, dans lequel la fragilisation est effectuée par refroidissement à une température inférieure à - 100°C, plus encore de préférence inférieure à -150°C.

3. Procédé selon la revendication 1 ou 2, dans lequel la couche de liaison (3, 3', 3", 3''', 3^{IV}) est sélectionnée parmi l'un des matériaux suivants :
- silicones ;
- plastiques, en particulier
- thermoplastiques,
- plastiques thermodurcissables,
- élastomères ou
- cires.

4. Procédé selon la revendication 1 ou 2, dans lequel la couche de liaison (3, 3', 3", 3''') est sélectionnée parmi un ou plusieurs des matériaux suivants :
- composants organiques, en particulier molécules organiques et/ou
- composants anorganiques, en particulier molécules anorganiques et/ou
- métaux, en particulier ions métalliques et/ou
- alliages métalliques et/ou
- céramiques.

5. Procédé selon l'une des revendications précédentes, dans lequel, pour la fragilisation, en particulier le refroidissement, un dissipateur thermique (9, 9', 9", 9''', 9i^{v}, 9^{V}) traversé en particulier par le fluide réfrigérant (18) avec une surface de refroidissement (9, 9k', 9k", 9k''') est employé, dans lequel la surface de refroidissement présente en particulier une conductivité thermique entre 0,1 W/(m*K) et 5000 W/(m*K), de préférence entre 1 W/(m*K) et 2500 W/(m*K), plus encore de préférence entre 10 W/(m*K) et 1000 W/(m*K), de manière la plus préférée entre 100 W/(m*K) et 450 W/(m*K).

6. Procédé selon l'une des revendications précédentes, dans lequel un premier support d'échantillon pour maintenir le premier substrat, présentant en particulier le dissipateur thermique (9, 9', 9", 9''', 9i^{v}, 9^{V}) et/ou un second support d'échantillon pour maintenir le second substrat, présentant en particulier le dissipateur thermique (9, 9', 9", 9''', 9i^{v}, 9^{V}), est/sont employé(s) lors de la séparation.

7. Procédé selon l'une des revendications précédentes, **caractérisé en ce que** la couche de liaison (3, 3', 3", 3''', 3^{IV}) reçoit des ultrasons pendant et/ou après le refroidissement et/ou la fragilisation.
